# EUROPEAN PATENT APPLICATION

(11) **EP 1 073 325 A2**
(43) Date of publication of application: **31.01.2001**
(21) Application number: 00306049.8
(22) Date of filing: 17.07.2000
(51) Int. Cl.: H05K 13/08, H05K 13/04

(54) **Testing and transporting semiconductor chips**

(30) Priority: 27.07.1999 US 145761 P; 28.06.2000 US 605341
(71) Applicant: LUCENT TECHNOLOGIES INC., Murray Hill, New Jersey 07974-0636 (US)
(72) Inventor: Akerson, Jeffrey John, Northampton, PA 18067 (US); Seitzer, Philip William, Bethlehem, PA 18017 (US); Vasudevan, Keelathur N., Macungie, PA 18062 (US)
(74) Representative: Buckley, Christopher Simon Thirsk

(57) **Abstract**

An apertured, punched plastic carrier tape with a pressure sensitive adhesive backing is loaded with ICs. The tape is wound on supply and take-up reels of a cassette. The cassette is adapted to be driven by a tape handler located in the factory or at a customer location where testing of the ICs takes place. The tape handler includes the necessary active components (e.g., a tape indexing mechanism, a chip ejector, etc.) for driving the tape and removing chips from it. As such the cassette has at least two cavities adapted to receive the indexing mechanism that advances the carrier tape in a controlled fashion and a chip ejector mechanism that, in conjunction with a pick-and place tool, allows IC chips to be removed from the carrier tape. In addition, the cassette has at least one window that permits access to the topside of the chips in the tape for the purpose of performing various electrical tests (e.g., via an electrical probe) or vision tests (e.g. via a camera) and/or to permit bad chips to be removed from the tape. In one embodiment, a first cassette contains chips as yet unknown as being either good or bad, and if a chip tests as bad, it may be replaced with a good chip (e.g., via a pick-and-place tool). In another embodiment, a second cassette contains only known-good chips that serve as the source of good replacement chips accessed by the pick-and-place tool. In yet another embodiment, the cassette includes a plurality of windows: one for performing the aforementioned tests, one for removing/replacing chips, and optionally one for viewing an identification marker on the backside of each chip (e.g., via a pattern recognition system).

## Description

### Cross-Reference to Related Applications

This application claims priority from provisional application Serial No. 60/145,761 filed on July 27, 1999.

### Field of the Invention

This invention relates generally to the testing and transporting semiconductor chips or die and, more particularly, techniques and apparatus for testing and transporting integrated circuit (IC) chips or die located on a chip carrier tape.

### Background of the Invention

As described by T. D. Dudderar *et al*. in US Patent No. 5,966,903 issued on October 19, 1999, a variety of systems for conveying finished IC chips from the IC singulation operation to the IC packaging operation are available commercially. This patent is incorporated herein by reference. Many of these systems use an apertured, punched plastic carrier tape with a pressure sensitive adhesive backing, referred to as the *carrier tape*, as more particularly described in Industry Standard EIA/IS-747 published by the Electronic Industries Association, Arlington, VA. Chips are mounted in the apertures with a pick-and-place tool and are retained in the apertures by the pressure sensitive adhesive backing. A widely used carrier tape system has two parallel rails of adhesive backing that extend along the underside of the apertured carrier tape. This type of carrier tape is described by C. Gutentag in US Patent No. 5,203,143 issued on April 20, 1993 and incorporated herein by reference. After the carrier tapes are loaded, the tapes can be conveyed to the next assembly operation, or more typically, are reeled for temporary storage. Tapes are then unreeled and the chips are picked from the carrier tape to be placed in a package assembly machine. With conventional pick-and-place tools the chips, which are carried circuit side up on the carrier tape, are seized on the circuit side by a vacuum head of the pick-and-place machine and inserted circuit side up into the next assembly station. For normal surface mount and wire bonded packages the circuit-side-up position of the chip is the orientation desired. However, for flip-chip packages this orientation is upside down.

Various methods have been employed to adapt carrier tape systems for flip-chip packaging. One of these is the High Speed Bare Die Dispenser available from Tempo Electronics, Los Angeles, CA. This system utilizes and inverter arm and two pick-and-place operations to reverse the orientation of the chips. Another system that utilizes only a single pick-and-place operation and picks the chips from the backside of the carrier tape is described in the Dudderar patent, *supra*.

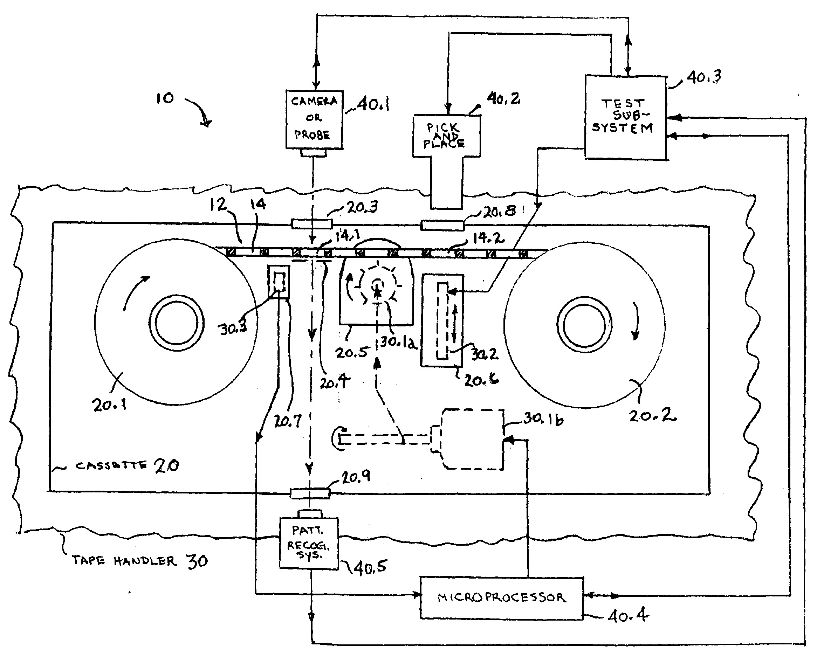

For optimum performance the apertures in the adhesive backing are custom fitted to the size of the chips being carried. The custom fit may be approached using different strategies, as described by T. D. Dudderar *et al*. in copending patent application Serial No. 09/134,843 filed on August 14, 1998 as a continuation-in-part of the aforementioned Dudderar *et al*. patent. This application is also incorporated herein by reference. Thus, the adhesive backing may be pre-punched by the carrier tape supplier and provided to the assembly operation in punched form. Alternatively, as shown in FIG. 15 of the Dudderar *et al*. application, an unpunched carrier tape is provided on a supply reel to a punch station where the adhesive backing on the carrier tape is punched to form apertures custom fitted to the chips being processed. The carrier tape then proceeds a loading station where the chips are loaded onto the carrier tape with a conventional pick-and-place tool. The loaded tape is then reeled onto a take up reel to be ready for the assembly operation. The application states that the carrier tape is conveyed from one station to another by drive sprockets that engage sprocket holes in the carrier tape and coordinate movement of the tape with the station operations.

To date, however, the IC industry has focused on using such tapes in the packaging of IC chips but not in testing the chips. Yet, a need remains in the IC art for a more effective way to handle IC chips during testing operations in the factory as well as at customers' premises, and for a safe, convenient and inexpensive way to ship ICs to customers.

### Summary of the Invention

In accordance with one aspect of our invention, an apertured, punched plastic carrier tape with a pressure sensitive adhesive backing is loaded with ICs. The tape is wound on supply and take-up reels of a passive cassette; that is, to keep cost to a minimum the cassette does not contain active devices or circuits that may be necessary to carry out various indexing and pick operations. Low cost makes it feasible for the cassette to be used as a shipping container. Instead, the cassette is adapted to be driven by a tape handler located in the factory or at a customer location where testing of the ICs takes place. The tape handler includes the necessary active components (e.g., a tape indexing mechanism, a chip ejector mechanism, etc.) As such the cassette has at least two cavities adapted to receive the indexing mechanism that advances the carrier tape in a controlled fashion and a chip ejector mechanism that, in conjunction with a pick-and place tool, allows IC chips to be removed from the carrier tape. In addition, the cassette has at least one window that permits access to the topside of the chips in the tape for the purpose of performing various electrical tests (e.g., via an electrical probe) or vision tests (e.g. via a camera) and/or to permit chips to be removed from the tape. In one embodiment, a first cassette contains chips as yet unknown as being either good or bad, and if a chip tests as bad, it may be replaced with a good chip (e.g., via a pick-and-place tool). In another embodiment, a second cassette contains only known-good chips that serve as the source of good replacement chips accessed by the pick-and-place tool. In yet another embodiment, the cassette includes a plurality of windows: one for performing the aforementioned tests, one for removing/replacing chips, and optionally one for viewing an identification marker on the backside of each chip (e.g., via a pattern recognition system).

### Brief Description of the Drawing

Our invention, together with its various features and advantages, can be readily understood from the following more detailed description taken in conjunction with the accompanying drawing, in which the sole figure is a schematic, block-diagrammatic view of system, tape handler and cassette in accordance with various aspects of our invention.

### Detailed Description of the Invention

With reference now to the figure, a system 10 for testing IC chips comprises a cassette 20 containing a carrier tape 12 that has chip sites pre-loaded with semiconductor die or chips 14. For example, may be IC chips positioned circuit side up (hereinafter referred to as the *topside* of the chip). The system 10 further includes a tape handler 30 into which the cassette is removably inserted for driving the carrier tape, and an array of peripheral equipment 40.1-5 used to perform a variety of functions associated with testing and/or removing chips and, if so desired, replacing bad chips with good chips.

More specifically, the cassette 20 includes a supply reel 20.1 and a take up reel 20.2, at least one test station window 20.3 and an associated rigid backing surface 20.4, a first cavity 20.5 for receiving a component of an indexing mechanism (e.g., a sprocket wheel 30.1) located in the tape handler 30 and a second cavity 20.6 for receiving a component of an ejector mechanism (e.g., an ejector pin 30.2) also contained within the tape handler. The carrier tape 12 is unwound from the supply reel 20,1, transported across the backing surface 20.4 and wound up on the take up reel 20.2. Movement of the tape is under control of the indexing mechanism, which includes sprocket indexing wheel 30.1a that engages sprocket holes (not shown) in the tape and a motor 30.1b that drives the wheel 30.1a. The motor is, in turn, under the control of microprocessor 40.4.

The tape itself may be, for example, any apertured, punched plastic carrier tape with a pressure sensitive adhesive backing that permits the topside of the chips to be presented under the window 20.3 and, for reasons explained below, allows access to the backside of the chips. Illustratively a tape of the type described in the Gutentag patent, *supra*, may be used. One such tape is sold under the trademark SURFTAPE by Tempo Electronics, Los Angeles, CA and is currently preferred for use in our invention.

The tape is moved in controlled increments so that the chips 14, one at a time, are presented in registration with the test station window 20.3. In this location the chip 14.1, for example, is tested by equipment 40.1. This equipment may test the chips in a number of conventional ways; e.g., either electrically by a probe or visually by a vision system, or both. (In the case of a probe making physical contact with the tape, the backing surface 20.4 provides support for the tape so that its vertical position is fixed when the probing operation is taking place.) The data generated by the test is provided to a test subsystem 40.3, which may be a computer loaded with specification data and programs to run comparisons. The subsystem 40.3 decides whether the chip meets predetermined specifications; i.e., whether the chip is good or bad. Electrical tests might include, for example, I-V measurements or functionality tests; vision tests might include identification of mechanical defects or an observation that a chip is missing at that chip site location in the carrier.

If a chip is found to be good, it simply remains in the tape chip site for later use. On the other hand, if a chip is found to be bad, the test subsystem sends a signal to the pick-and-place tool 40.2 to remove the chip downstream at the pick-and-place station, and if so desired to replace it with a good chip. Alternatively, the pick-and-place operation could be performed at the same location as the test operation. (The source of the good replacement chips could itself be another cassette of the type described above but wherein the carrier tape is loaded with chips that have priorly undergone the testing/replacement process described herein.) When the test subsystem has completed all of the tests to be run on a chip, it sends a signal to the microprocessor 40.4 that it is *done* and to move the tape so that the next chip site is under test station window 20.3.

The pick-and-place function occurs when the chip moves downstream to the pick-and-place station at a second window 20.8 in the cassette. Here, the vacuum head of the pick-and-place tool 40.2 extends through the window 20.8 to the topside of the chip and concurrently an ejector pin 30.2 pushes the chip from its backside, both under control of signals from the test subsystem. The tool 40.2 then removes the bad chip from the tape leaving behind an empty chip site, picks a good chip from a known-good source, and places the good chip in the same site via the window 20.8. (A similar procedure would be followed for the case of a chip missing from a site.) In this fashion, after all of the bad/missing chips have been replaced, the take up reel 20.2 contains only good chips.

Knowledge of the precise position of the chip sites in the tape in relationship to the testing station and the pick-and-place station is important. The precision nature of the tape itself makes it easier to accurately determine the site locations. A simple counter (not shown) in the tape handler could be used to count locations on the tape. Alternatively, if an active form of positional control is desired, the tape handler may be provided with a sensor 30.3, the output of which is delivered to a microprocessor 40.4, which, in turn, provides a corresponding input to the test subsystem 40.3. In this case, the cassette 20 would have a third cavity 20.7 for receiving and positioning the sensor 30.3 at a location where it can *see* the tape; for example, at a location under the tape near the supply reel. However, other sensor locations along the tape are also suitable.

Finally, where the chips have an identification marker (e.g., a laser scribed alpha numeric or a barcode) on their backsides, a commercially available pattern recognition system 40.5 may be used to supply the identification information to the test subsystem. Illustratively, the cassette is provided with a third window 20.9 through which the pattern recognition system reads the backside of the chips, typically, though not necessarily, while each is positioned at the test station window 20.3. In this case, the backing surface 20.4 should be apertured (as shown) or otherwise rendered transparent to light that reflects the marker image back to the system 40.5. For purposes of simplicity the windows 20.3 and 20.9 are shown to be on opposite sides of the cassette and aligned with one another. Alternative positions for the windows are suitable, for example, to accommodate space constraints within the cassette or tape handler. If the two windows are not aligned as shown, then well-known optics (e.g., mirrors) may be used to convey the image of the backside of the chip to the system 40.5.

It is to be understood that the above-described arrangements are merely illustrative of the many possible specific embodiments that can be devised to represent application of the principles of the invention. Numerous and varied other arrangements can be devised in accordance with these principles by those skilled in the art without departing from the spirit and scope of the invention.

## Claims

1. A system for testing semiconductor chips, comprising
a **first** cassette that includes (1) a supply reel and a take up reel, (2) an apertured carrier
tape wound on said reels, said tape having sprocket holes and chip sites at which said chips are pre-loaded topside up, said tape allowing access to both the topside and backside of said chips, (3) a test station window located in a surface of said cassette so as to provide access to the topside of a chip in registration with said window, (4) a first cavity for receiving an indexing mechanism for moving the tape and for bringing chips sites sequentially into registration with said test station window, and (5) a second cavity for receiving an ejector mechanism for pushing on the backside of a chip,
a tape handler into which said first cassette is removably inserted, said handler including (1) said indexing mechanism comprising a sprocket wheel for engaging said sprocket holes in said tape and a motor for rotating said wheel, and (2) said ejector mechanism, and
peripheral equipment including (1) testing equipment for testing chips presented to said test station window and for identifying good chips and bad chips and (2) pick-and-place equipment that cooperates with said ejector mechanism for removing bad chips from said tape and for replacing them with good chips.

2. The invention of claim 1 wherein said pick-and-place equipment has removed a bad chip from a chip site location in said first cassette and further including an essentially identical second cassette that contains only known-good chips, said pick-and-place equipment picking a known-good chip from said second cassette and placing it in the chip site location of said removed bad chip.

3. The invention of claim 1 wherein said tape handler includes a sensor for identifying
the location of chips sites on said tape, and said first cassette includes a third cavity for receiving said sensor.

4. The invention of claim 1 wherein said first cassette includes a rigid backing surface under said test station window that supports said tape when a chip in registration with said window is physically contacted by said testing equipment.

5. The invention of claim 1 wherein said pick-and-place equipment performs its operations via said test station window.

6. The invention of claim 1 wherein a surface of said first cassette includes a pick-and-place window located downstream of said test station window, said ejector mechanism is aligned under said pick-and-place window, and said pick-and-place equipment performs its functions via said pick-and-place window.

7. A cassette for carrying and testing semiconductor chips comprising (1) a supply reel
and a take up reel, (2) an apertured carrier tape wound on said reels, said tape having sprocket holes and chip sites at which said chips are pre-loaded topside up, said tape allowing access to both the topside and backside of said chips, (3) a station window located in a surface of said cassette so as to provide access to the topside of a chip in registration with said window, (4) a first cavity for receiving an indexing mechanism for moving the tape and for bringing chips sites sequentially into registration with said station window, and (5) a second cavity for receiving an ejector mechanism for pushing on the backside of a chip.

8. The invention of claim 7 wherein said cassette includes a rigid backing surface under said test station window that supports said tape when a chip in registration with said window is physically contacted by testing equipment.

9. The invention of claim 7 wherein a surface of said cassette includes a pick-and-place window located downstream of said station window and said ejector mechanism cavity is positioned so that said ejector mechanism is aligned under said pick-and-place window.

10. The invention of claim 7 wherein said cassette comprises a shipping container for transporting said pre-loaded tape from one location to another.

11. The invention of claim 7 wherein said carrier tape contains chips as yet unknown as being either good or bad, and said window is a test window that permits said chips to be tested.

12. The invention of claim 7 wherein said carrier tape contains only known-good chips, and said window permits access to a pick-and-place tool to remove chips from said tape.
